# EUROPÄISCHE PATENTANMELDUNG

(11) **EP 1 521 311 A2**
(43) Veröffentlichungstag der Anmeldung: **06.04.2005**
(21) Anmeldenummer: 04022801.7
(22) Anmeldetag: 24.09.2004
(51) Int. Cl.: H01L 33/00, H01S 5/323

(54) **Strahlungsemittierender Halbleiterkörper mit Confinement-Schichten**

(30) Priorität: 30.09.2003 DE 10345412; 01.12.2003 DE 10355962
(71) Anmelder: Osram Opto Semiconductors GmbH, 93049 Regensburg (DE)
(72) Erfinder: Linder, Norbert, 93173 Wenzenbach (DE); Pietzonka, Ines, 93049 Regensburg (DE)
(74) Vertreter: Epping Hermann & Fischer

(57) **Zusammenfassung**

Die Erfindung bezieht sich auf einen strahlungsemittierenden Halbleiterkörpen mit einer auf InₓAl_{y}Ga_{1-x-y}P mit 0≤x≤1, 0≤y≤1, 0≤x+y≤1 basierenden strahlungsemittierenden aktiven Schicht (2), die zwischen einer ersten Confinement-Schicht (3) und einer zweiten Confinement-Schicht (4) angeordnet ist, wobei zumindest eine der Confinement-Schichten (3,4) InₓAl_{y}Ga_{1-x-y}PᵤN₁₋ᵤ mit 0≤x≤1, 0≤y≤1, 0≤x+y≤1 und 0≤u<1 und/oder B_{z}InₓAl_{y}Ga_{1-x-y-z}PᵤN₁₋ᵤ mit 0≤x≤1, 0≤y≤1, 0<z≤1, 0≤x+y+z≤1 und 0≤u<1 oder ein II-VI-Halbleitermaterial enthält.

## Beschreibung

Die Erfindung betrifft einen strahlungsemittierenden Halbleiterkörper nach dem Oberbegriff des Patentanspruchs 1 sowie einen strahlungsemittierenden Halbleiterkörper nach dem Oberbegriff des Patentanspruchs 6.

Herkömmliche Halbleiterkörper der erstgenannten Art weisen oftmals Confinement-Schichten auf InGaAlP-Basis auf, zwischen denen die aktive Schicht angeordnet ist. Diese Confinement-Schichten bilden für die im Betrieb injizierten Ladungsträger Barrieren, die dem Einschluss der Ladungsträger bzw. einer Erhöhung der Verweildauer der Ladungsträger in der aktiven Schicht dienen.

Wünschenswert ist dabei ein möglichst vollständiger Einschluss bzw. eine lange Verweildauer der Ladungsträger in der aktiven Schicht, da Ladungsträger außerhalb der aktiven Schicht keinen nennenswerten Beitrag zur Strahlungserzeugung leisten.

Confinement-Schichten sind üblicherweise gitterangepasst an die aktive Schicht ausgeführt. Bei einer unzureichenden Gitteranpassung besteht die Gefahr, dass mechanische Verspannungen zwischen Confinement-Schicht und aktiver Schicht sowie Defekte im Kristallgitter entstehen. Derartige Defekte können die Strahlungsausbeute verschlechtern, da sie beispielsweise die nichtstrahlende Rekombinbation von Ladungsträgern begünstigen können.

Allerdings ist bei gitterangepassten Confinement-Schichten auf InGaAlP-Basis die erreichbare Barrierenhöhe vergleichsweise gering. Die maximale Barrierenhöhe wird hierbei mit AlInP-Confinement-Schichten erzielt. Aufgrund der begrenzten Barrierenhöhe treten bei derartigen Halbleiterkörpern sogenannte Leckströme von Ladungsträgern auf, die nicht zur Strahlungserzeugung beitragen.

Ein eng verwandtes Problem des Ladungsträgereinschlusses tritt bei strahlungsemittierenden Quantentopfstrukturen auf InGaAlP-Basis auf. Der Einschluss der Ladungsträger erfolgt hier in dem Quantentopf bzw. den Quantentöpfen selbst. Eine Quantentopfstruktur auf InGaAlP-Basis weist eine Mehrzahl von aufeinanderfolgenden Quantentopf- und Barriereschichten auf. Wie schon im Zusammenhang mit den Confinement-Schichten erläutert wurde, tritt hier das Problem auf, dass die Höhe der Barriereschichten im Fall der Gitteranpassung limitiert ist.

Es ist Aufgabe der vorliegenden Erfindung, einen strahlungserzeugenden Halbleiterkörper auf InGaAlP-Basis mit verbessertem Ladungsträgereinschluss zu schaffen.

Diese Aufgabe wird durch einen Halbleiterkörper nach Anspruch 1 bzw. einen Halbleiterkörper nach Anspruch 6 gelöst. Vorteilhafte Weiterbildungen der Erfindung sind Gegenstand der abhängigen Ansprüche.

Bei einer ersten Ausführungsform der Erfindung ist ein strahlungsemittierender Halbleiterkörper mit einer auf InₓAl_{y}Ga_{1-x-y}P mit 0≤x≤1, 0≤y≤1, 0≤x+y≤1 basierenden strahlungsemittierenden aktiven Schicht, die zwischen einer ersten und einer zweiten Confinement-Schicht angeordnet ist, vorgesehen, wobei zumindest eine der Confinement-Schichten InₓAl_{y}Ga_{1-x-y}PᵤN₁₋ᵤ (InAlGaPN) mit 0≤x≤1, 0≤y≤1, 0≤x+y≤1 und 0≤u<1, B_{z}InₓAl_{y}Ga_{1-x-y-z}PᵤN₁₋ᵤ mit 0≤x≤1, 0≤y≤1, 0<z≤1, 0≤x+y+z≤1 und 0≤u<1 (BInAlGaPN) oder ein II-VI-Halbleitermaterial, vorzugsweise ZnₓMg₁₋ₓS_{y}Se_{1-y} mit 0≤x≤1 und 0≤y≤1 (ZnMgSSe) enthält. Bevorzugt enthält zumindest eine der Confinement-Schichten eine quaternäre Verbindung mit x>0, y>0 und x+y<1, und besonders bevorzugt eine quinternäre Verbindung, wobei zusätzlich u>0 gilt.

Mit den genannten Materialien InAlGaPN und BInAlGaPN oder einem II-VI-Halbleitermaterial wie zum Beispiel ZnMgSSe kann eine Confinement-Schicht für eine aktive Schicht auf InGaAlP-Basis gebildet werden, die vorteilhafterweise eine größere Barrierenhöhe als eine InGaAlP-Confinement-Schicht, insbesondere eine AlInP-Confinement-Schicht, aufweist.

Bevorzugt ist die Confinement-Schicht bzw. sind die Confinement-Schichten gitterangepasst ausgeführt. Vorteilhafterweise sind bei der Erfindung mit den genannten Materialien für die Confinement-Schichten sowohl eine ausreichend hohe Barrierenhöhe als auch eine Gitteranpassung der Confinement-Schichten an die aktive Schicht realisierbar.

Es sei aber angemerkt, dass im Rahmen der Erfindung eine Gitteranpassung der Confinement-Schichten nicht zwingend erforderlich ist. Aufgrund der vorteilhaft großen Barrierenhöhe der Confinement-Schichten kann auch auf die Gitteranpassung verzichtet und eine - in der Regel tensile - Verspannung zwischen aktiver Schicht und Confinement-Schicht in Kauf genommen werden. Eine Erhöhung der Strahlungsausbeute kann in diesem Fall dadurch erzielt werden, dass die verspannungsinduzierten Verluste durch den verbesserten Einschluss der Ladungsträger überkompensiert werden.

Vorzugsweise enthalten bei der Erfindung beide Confinement-Schichten InAlGaPN, BInAlGaPN oder ein II-VI-Halbleitermaterial, wobei besonders bevorzugt die erste und die zweite Confinement-Schicht dieselbe Zusammensetzung aufweisen. Bei dieser Ausgestaltung der Erfindung sind somit beidseits der aktiven Schicht Confinement-Schichten mit einer vorteilhaft großen Barrierenhöhe vorgesehen. Dies führt zu einem effizienten Einschluss der Ladungsträger bzw. einem besonders niedrigen Leckstrom.

Bei einer bevorzugten Weiterbildung der Erfindung sind die erste und/oder die zweite Confinement-Schicht in einem Abstand von der aktive Schicht angeordnet, der kleiner als die Diffusionslänge ist. Hiermit wird erreicht, dass ein möglichst hoher Anteil der in die aktive Schicht injizierten Ladungsträger vom Einschluss durch die Confinement-Schichten erfasst wird. Insgesamt wird so die Effizienz der Strahlungserzeugung weiter erhöht.

Bei einer zweiten Ausführungsform der Erfindung ist ein strahlungsemittierender Halbleiterkörper mit einer auf InₓAl_{y}Ga_{1-x-y}P mit 0≤x≤1, 0≤y≤1, 0≤x+y≤1 basierenden strahlungsemittierenden aktiven Schicht mit einer Quantentopfstuktur, die eine oder mehrere Barrierenschichten aufweist, vorgesehen, wobei die Barrierenschicht bzw. mindestens eine der Barrierenschichten InₓAl_{y}Ga_{1-x-y}PᵤN₁₋ᵤ mit 0≤x≤1, 0≤y≤1, 0≤x+y≤1 und 0≤u<1 und/oder B_{z}InₓAl_{y}Ga_{1-x-y-z}PᵤN₁₋ᵤ mit 0≤x≤1, 0≤y≤1, 0<z≤1, 0≤x+y+z≤1 und 0≤u<1 oder ein II-VI-Halbleitermaterial enthält.

Wiederum kann mit den genannten Materialien InAlGaPN und BInAlGaPN oder einem II-VI-Halbleitermaterial wie zum Beispiel ZnMgSSe vorteilhafterweise eine größere Barrierenhöhe als mit InGaAlP-Barriereschichten und damit ein effizienterer Einschluss der Ladungsträger erzielt werden, wobei gegenüber dem ersten Ausführungsbeispiel sich der Einschluss auf die einzelnen Quantentöpfe innerhalb der aktiven Schicht bezieht.

Wie bei der ersten Ausführungsform ist es im Hinblick auf einen möglichst effizienten Ladungsträgereinschluss auch bei der zweiten Ausführungsform vorteilhaft, den Quantentopf bzw. die Quantentöpfe beidseitig mit Barriereschichten zu umgeben, die InAlGaPN, BInAlGaPN oder ein II-VI-Halbleitermaterial enthalten und bevorzugt die gleiche Zusammensetzung aufweisen.

Eine weitere Ausgestaltung der Erfindung besteht in einer Kombination der ersten und der zweiten Ausführungsform, so dass bei einem strahlungsemittierenden Halbleiterkörper die aktive Schicht eine Quantentopfstruktur gemäß der zweiten Ausführungsform umfasst, wobei die aktive Schicht ein- oder beidseitig von Confinement-Schichten nach der ersten Ausführungsform umgeben ist. Bei dieser Ausgestaltung enthalten also sowohl die Barriereschicht bzw. Barriereschichten der Quantentopfstruktur in der aktiven Schicht als auch mindestens eine, vorzugsweise beide Confinement-Schichten InAlGaPN, BInAlGaPN oder ein II-VI-Halbleitermaterial wie zum Beispiel ZnMgSSe.

Bevorzugt ist der Halbleiterkörper bei der Erfindung als Lichtemissionsdiode, beispielsweise als LED oder Laserdiode ausgeführt. Mit der Erfindung kann bei diesen Bauelementen eine deutliche Effizienzsteigerung erzielt werden. Bei Laserdioden kommt hinzu, dass durch den erfindungsgemäß verbesserten Ladungsträgereinschluss die Schwellenstromdichte vorteilhaft gesenkt werden kann.

Weitere Merkmale, Vorzüge und Zweckmäßigkeiten der Erfindung ergeben sich aus den nachfolgend beschriebenen Ausführungsbeispielen in Verbindung mit den Figuren 1 bis 3.

Es zeigen
Figur 1 eine schematische Darstellung eines ersten Ausführungsbeispiels eines erfindungsgemäßen Halbleiterkörpers,
Figur 2 eine schematische Darstellung eines zweiten Ausführungsbeispiels eines erfindungsgemäßen Halbleiterkörpers, und
Figur 3 eine schematische Darstellung eines dritten Ausführungsbeispiels eines erfindungsgemäßen Halbleiterkörpers.

Gleiche oder gleichwirkende Elemente sind in den Figuren mit demselben Bezugszeichen versehen.

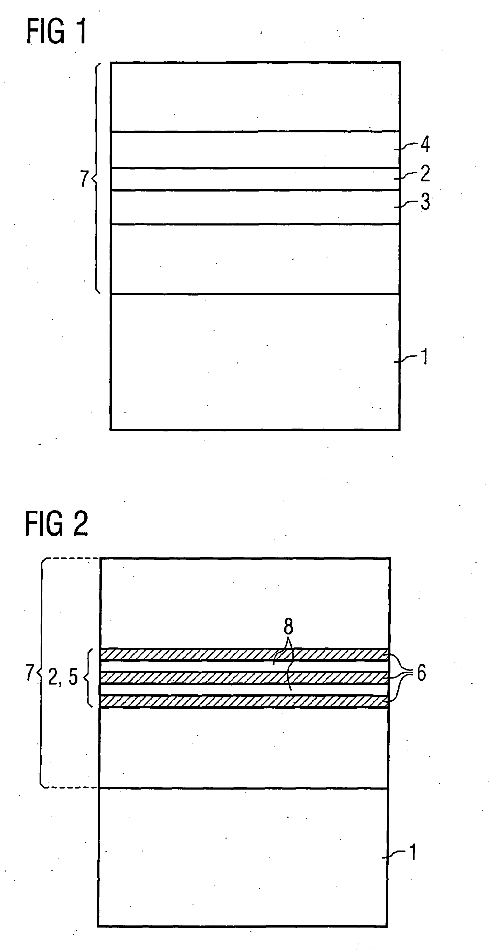

Das in Figur 1 dargestellte erste Ausführungsbeispiel weist einen Halbleiterkörper mit einem Substrat 1 auf, auf dem eine Halbleiterschichtenfolge 7 aufgebracht ist. Mit dieser Halbleiterschichtenfolge 7 kann beispielsweise eine LED-Struktur realisiert werden.

Die Halbleiterschichtenfolge 7 umfasst eine strahlungserzeugende aktive Schicht auf der Basis von InAlGaP. Hierunter ist im Rahmen der Erfindung zu verstehen, dass die aktive Schicht aus InAlGaP besteht oder InAlGaP enthält, wobei im letzteren Fall die aktive Schicht auch noch andere Materialien enthalten kann. Vorzugsweise ist hierunter zu verstehen, dass die aktive Schicht keinen Nitridverbindungshalbleiter, also InₓAl_{y}Ga_{1-x-y}PᵤN₁₋ᵤ mit 0≤x≤1, 0≤y≤1, 0≤x+y≤1 und 0≤u<1 enthält, und insbesondere aus einer oder mehreren Schichten aus InAlGaP besteht.

Weitergehend kann die aktive Schicht auch mehrlagig gebildet sein, wobei nur Teilbereiche der aktiven Schicht InAlGaP enthalten und/oder die InAlGaP-Zusammensetzung in Teilbereichen der aktiven Schicht unterschiedlich ist. Dies umfasst insbesondere auch Quantentopfstrukturen, die im Folgenden noch genauer erläutert werden.

Der aktiven Schicht sind beidseits gitterangepasste Confinementschichten 3,4 nachgeordnet, die bevorzugt unmittelbar an die aktive Schicht 2 angrenzen. Mindestens eine der beiden Confinement-Schichten enthält InAlGaPN, BInAlGaPN oder ein II-VI-Halbleitermaterial wie zum Beispiel ZnMgSSe. Für einen möglichst guten Ladungsträgereinschluss ist es dabei vorteilhaft, dass beide Confinement-Schichten InAlGaPN, BInAlGaPN oder ein II-VI-Halbleitermaterial wie zum Beispiel ZnMgSSe enthalten, bevorzugt mit der gleichen Zusammensetzung.

Gegenüber InGaAlP-Confinement-Schichten nach dem Stand der Technik kann mit den genannten Materialen bei der Erfindung die Barrierenhöhe in Bezug auf die aktive Schicht 2 erhöht und so der Ladungsträgereinschluss deutlich verbessert werden. Dies führt zu vorteilhaft geringen Leckströmen bzw. einer besonders effizienten Strahlungserzeugung.

Falls die Confinement-Schichten 3,4 nicht unmittelbar an die aktive Schicht grenzen, ist der Abstand zwischen Confinement-Schicht 3,4 und aktiver Schicht 2 bei der Erfindung bevorzugt kleiner als die Diffusionslänge der Ladungsträger in der aktiven Schicht.

Die Diffusionslänge ist ein Maß für den räumlichen Aufenthaltsbereich eines Ladungsträgers während seiner mittleren Lebensdauer. In einem Abstand von der aktiven Schicht, der größer als die Diffusionslänge ist, nimmt die Anzahl der in die aktive Schicht injizierten Ladungsträger stark ab. Entsprechend sinkt der Einfluss bzw. die Effizienz der Confinement-Schichten, wobei sich auch die vorteilhaft erhöhte Barrierenhöhe nur noch bezüglich der verbleibenden Ladungsträger positiv auswirken kann.

Das in Figur 2 dargestellte zweite Ausführungsbeispiel weist wie das erste Ausführungsbeispiel einen Halbleiterkörper mit einem Substrat 1 auf, auf dem eine Halbleiterschichtenfolge 7 aufgebracht ist. Die Halbleiterschichtfolge 7 umfasst wiederum eine aktive strahlungserzeugende Schicht auf der Basis von InAlGaP und kann beispielsweise als Laserstruktur ausgeführt sein.

Die aktive Schicht 2 ist bei dem zweiten Ausführungsbeispiel als Quantentopfstruktur in Form einer Doppelquantentopfstruktur (DQW, double quantum well) mit drei Barriereschichten 6 und zwei zwischen je zwei Barriereschichen 6 angeordneten Quantentopfschichten 8 auf InGaAlP-Basis ausgeführt. Bevorzugt sind die Quantentopfschichten 8 reine InGaP-Schichten.

Es versteht sich, dass im Rahmen der Erfindung auch andere Quantentopfstrukturen, beispielsweise Einfachquantentopfstrukturen oder Mehrfachquantentopfstrukturen mit mehr als zwei Quantentopfschichten vorgesehen sein können.

Die Barriereschichten 6 enthalten InAlGaPN, BInAlGaPN oder einem II-VI-Halbleitermaterial wie zum Beispiel ZnMgSSe. Hiermit können größere Barrierehöhen als mit herkömmlichen InGaAlP-Barriereschichten erzielt werden, wodurch der Ladungsträgereinschluss und in der Folge die Effizienz der Strahlungserzeugung vorteilhaft verbessert wird.

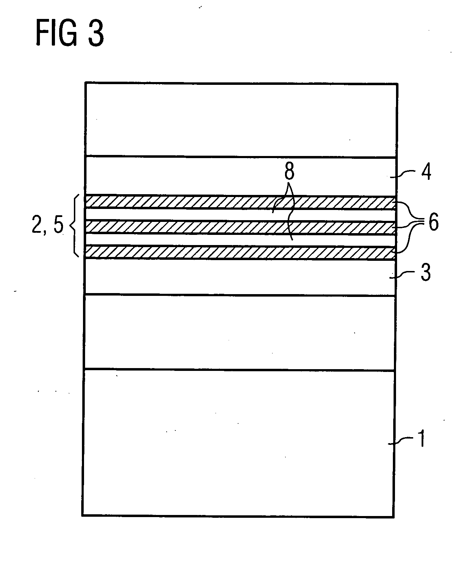

Das in Figur 3 dargestellte dritte Ausführungsbeispiel entspricht einer Kombination des ersten und des zweiten Ausführungsbeispiels.

Wie bei den vorhergehenden beiden Ausführungsbeispielen weist der Halbleiterkörper ein Substrat 1 mit einer darauf angeordenten Halbleiterschichtenfolge auf. Die Halbleiterschichtenfolge umfasst wie bei dem ersten Ausführungsbeispiel eine bzw. zwei InAlGaPN, BInAlGaPN oder ein II-VI-Halbleitermaterial enthaltende Confinement-Schichten 3,4, zwischen denen die aktive Schicht 2 auf InGaAlP-Basis angeordnet ist.

Die aktive Schicht enthält wie bei dem zweiten Ausführungsbeispiel eine Quantentopfstruktur 5 mit Barriereschichten 6 und dazwischenliegenden Quantentopfschichten 8 auf InGaAlP-Basis, wobei die Barriereschichten 6 InAlGaPN, BInAlGaPN oder ein II-VI-Halbleitermaterial enthalten.

Der verbesserte Ladungsträgereinschluss sowohl in der aktiven Schicht 2 insgesamt als auch in den einzelnen Quantentopfschichten 6 führt zu einem besonders effizienten Bauelement.

Es sei angemerkt, dass die Barrierenhöhe der Confinement-Schichten 3,4 bei dem dritten Ausführungsbeispiel nicht der Barrierehöhe der Barriereschichten 6 entsprechen muss. Insbesondere kann durch eine unterschiedliche Zusammensetzung dieser Schichten erreicht werden, dass die Barrierenhöhe der Confinement-Schichten 3,4 die Barrierenhöhe der Barrierenschichten übertrifft und somit ein zweifacher, gestaffelter Ladungsträgereinschluss realisiert wird.

Die Halbleiterschichtfolge 7 kann bei der Erfindung auch noch weitere Schichten enthalten. Insbesondere können zwischen Substrat 1 und aktiver Schicht 2 bzw. der ersten Confinement-Schicht 3 eine Pufferschicht und auf der dem Substrat abgewandten Seite der aktiven Schicht eine oder mehrere Kontaktschichten angeordnet sein. Weitergehend kann die aktive Schicht bzw. die aktive Schicht einschließlich der Confinement-Schichten zwischen zwei Mantel- oder Überzugsschichten angeordnet sein. Schließlich können insbesondere bei einer Ausführung als Halbleiterlaser ein gesonderter Wellenleiter bzw. optische Confinement-Schichten vorgesehen sein, der bzw. die die aktive Schicht allein oder die aktive Schicht einschließlich der oben beschriebenen Confinement-Schichten umgeben.

Ferner ist ein Substrat bei einem erfindungsgemäßen Halbleiterkörper nicht zwingend erforderlich und kann zur Bildung eines Dünnfilm-Bauelements von der Halbleiterschichtenfolge, die dann den Halbleiterkörper darstellt, abgelöst sein. Unter einem Dünnschichtbauelement ist hierbei ein Bauelement mit einer auf ein Aufwachssubstrat epitaktisch aufgewachsenen Hableiterschichtenfolge zu verstehen, wobei das Aufwachssubstrat zumindest teilweise von der Halbleiterschichtenfolge entfernt ist. Bevorzugt ist die Halbleiterschichtenfolge zur mechanischen Stabilisierung auf einen Träger aufgebracht.

Die Erläuterung der Erfindung anhand der Ausführungsbeispiele ist nicht als Beschränkung der Erfindung zu verstehen. Vielmehr umfasst die Erfindung auch alle anderen neuen Merkmale oder Kombinationen von Merkmalen, die im Rahmen der Ausführungsbeispiele oder der sonstigen Beschreibung offenbart sind, selbst wenn dies nicht Gegenstand eines Patentanspruchs ist.

## Patentansprüche

1. Strahlungsemittierender Halbleiterkörper mit einer auf InₓAl_{y}Ga_{1-x-y}P mit 0≤x≤1, 0≤y≤1, 0≤x+y≤1 basierenden strahlungsemittierenden aktiven Schicht (2)
die zwischen einer ersten Confinement-Schicht (3) und einer zweiten Confinement-Schicht (4) angeordnet ist,
**dadurch gekennzeichnet, dass**
zumindest eine der Confinement-Schichten (3,4) InₓAl_{y}Ga_{1-x-y}PᵤN₁₋ᵤ mit 0≤x≤1, 0≤y≤1, 0≤x+y≤1 und 0≤u<1 und/oder B_{z}InₓAl_{y}Ga_{1-x-y-z}PᵤN₁₋ᵤ mit 0≤x≤1, 0≤y≤1, 0<z≤1, 0≤x+y+z≤1 und 0≤u<1 oder ein II-VI-Halbleitermaterial enthält.

2. Strahlungsemittierender Halbleiterträger nach Anspruch 1,
**dadurch gekennzeichnet, dass**
die Confinement-Schichten (3,4) an die aktive Schicht gitterangepasst sind.

3. Strahlungsemittierender Halbleiterkörper nach Anspruch 1 oder 2,
**dadurch gekennzeichnet, dass**
die erste Confinement-Schicht (3) und die zweite Confinement-Schicht (4) InₓAl_{y}Ga_{1-x-y}PᵤN₁₋ᵤ mit 0≤x≤1, 0≤y≤1, 0≤x+y≤1 und 0≤u<1, B_{z}InₓAl_{y}Ga_{1-x-y-z}PᵤN₁₋ᵤ mit 0≤x≤1, 0≤y≤1, 0<z≤1, 0≤x+y+z≤1 und 0≤u<1 oder ein II-VI-Halbleitermaterial enthalten.

4. Strahlungsemittierender Halbleiterkörper nach einem der Ansprüche 1 bis 3,
**dadurch gekennzeichnet, dass**
die Zusammensetzung der ersten und der zweiten Confinement-Schicht (3,4) gleich ist.

5. Strahlungsemittierender Halbleiterkörper nach einem der Ansprüche 1 bis 4,
**dadurch gekennzeichnet, dass**
der aktiven Schicht (2) eine Diffusionslänge für die im Betrieb injizierten Ladungsträger zugeordnet ist,
und die erste und/oder die zweite Confinement-Schicht (3,4) in einem Abstand von der aktiven Schicht (2) angeordnet ist, der kleiner ist als die Diffusionlänge.

6. Strahlungsemittierender Halbleiterkörper mit einer auf InₓAl_{y}Ga_{1-x-y}P mit 0≤x≤1, 0≤y≤1, 0≤x+y≤1 basierenden strahlungsemittierenden aktiven Schicht (2) mit einer Quantentopfstruktur (5), die eine oder mehrere Barrierenschichten (6) aufweist,
**dadurch gekennzeichnet, dass**
die Barrierenschicht (6) bzw. mindestens eine der Barrierenschichten (6) InₓAl_{y}Ga_{1-x-y}PᵤN₁₋ᵤ mit 0≤x≤1, 0≤y≤1, 0≤x+y≤1 und 0≤u<1 und/oder B_{z}InₓAl_{y}Ga_{1-x-y-z}PᵤN₁₋ᵤ mit 0≤x≤1, 0≤y≤1, 0<z≤1, 0≤x+y+z≤1 und 0≤u<1 oder ein II-VI-Halbleitermaterial enthält.

7. Strahlungsemittierender Halbleiterkörper nach Anspruch 6,
**dadurch gekennzeichnet, dass**
die Quantentopfstruktur (5) mehrere Barriereschichten (6) mit der gleichen Zusammensetzung aufweist.

8. Strahlungsemittierender Halbleiterkörper nach Anspruch 6,
**dadurch gekennzeichnet, dass**
die aktive Schicht (2) zwischen zwei Confinement-Schichten (3,4) gemäß einem der Ansprüche 1 bis 5 angeordnet ist.

9. Strahlungsemittierender Halbleiterkörper nach einem der Ansprüche 1 bis 8,
**dadurch gekennzeichnet, dass**
das II-VI-Halbleitermaterial ZnₓMg₁₋ₓS_{y}Se_{1-y} mit 0≤x≤1 und 0≤y≤1 ist.

10. Strahlungsemittierender Halbleiterkörper nach einem der Ansprüche 1 bis 9,
**dadurch gekennzeichnet, dass**
gilt: x>0, y>0 und x+y<1.

11. Strahlungsemittierender Halbleiterkörper nach Anspruch 10,
**dadurch gekennzeichnet, dass**
gilt: u>0.

12. Strahlungsemittierender Halbleiterkörper nach einem der Ansprüche 1 bis 11,
**dadurch gekennzeichnet, dass**
der Halbleiterkörper eine Lichtemissionsdiode, insbesondere eine LED oder eine Laserdiode ist.
